# EUROPÄISCHE PATENTANMELDUNG

(11) **EP 1 271 172 A2**
(43) Veröffentlichungstag der Anmeldung: **02.01.2003**
(21) Anmeldenummer: 02100726.5
(22) Anmeldetag: 20.06.2002
(51) Int. Cl.: G01R 33/28, G01R 33/341

(54) **MR-Verfahren und MR-Anordnung mit Mitteln zur Erfassung von Positions- und/oder Lageänderungen von Spulen**

(30) Priorität: 21.06.2001 DE 10130071
(71) Anmelder: Philips Corporate Intellectual Property GmbH, 20099 Hamburg (DE); Koninklijke Philips Electronics N.V., 5621 BA Eindhoven (NL)
(72) Erfinder: Eggers, Holger c/o Philips Corporate Intellectual, 52066, Aachen (DE); Weiss, Steffen c/o Philips Corporate Intellectual, 52066, Aachen (DE)
(74) Vertreter: Volmer, Georg, Dipl.-Ing.

(57) **Zusammenfassung**

Die Erfindung betrifft ein MR-Verfahren und eine MR-Anordnung zur Ermittlung von MR-Bildern eines Untersuchungsbereichs eines Untersuchungsobjekts (10). Dabei wird eine mindestens eine bewegliche und/oder flexible Erregeispule (19) aufweisende Erregerspulenanordnung (21) zur Anregung des abzubildenden Untersuchungsbereichs und/oder eine mindestens eine bewegliche und/oder flexible Empfangsspule (61, 62, 63) aufweisende Empfangsspulenanordnung zur Erfassung von MR-Daten aus dem Untersuchungsbereich eingesetzt. Um MR-Bilder mit höherer Genauigkeit und insbesondere höherer örtlicher und räumlicher Auflösung gewinnen zu können, wird vorgeschlagen, Positions- und Lageinformationen der Empfangsspulen (61, 62, 63) bzw. der mindestens einen Erregerspule (19) zu ermitteln und die gewonnenen Informationen zur Korrektur der Eingangsdaten der Rekonstxuktion bzw. zur Korrektur des Anregungssignals der mindestens einen Erregerspule (19) zu verwenden. Damit sollen Bewegungen und/oder Deformationen von Spulen während der Akquisition von MR-Daten berücksichtigt werden.

## Beschreibung

Die Erfindung betrifft ein MR-Verfahren zur Ermittlung von MR-Bildern eines Untersuchungsbereichs eines Untersuchungsobjekts, wobei mittels einer mindestens eine bewegliche und/oder flexible Empfangsspule aufweisenden Emfpangsspulenanordnung MR-Daten aus dem Untersuchungsbereich erfasst werden und wobei aus den erfassten MR-Daten die MR-Bilder rekonstruiert werden. Weiter betrifft die Erfindung ein MR-Verfahren zur Ermittlung von MR-Bildern eines Untersuchungsbereichs eines Untersuchungsobjekts, wobei mittels einer mindestens eine bewegliche und/oder flexible Erregerspule aufweisenden Erregerspulenanordnung der abzubildende Untersuchungsbereich angeregt wird. Die Erfindung betrifft außerdem auch entsprechende MR-Anordnungen mit einer Empfangsspulenanordnung bzw. einer Erregerspulenanordnung und Mitteln zur Ermittlung von Positions- und Lageinformationen der Spulen. Schließlich betrifft die Erfindung auch ein Computerprogramm zur Umsetzung der MR-Verfahren und/oder zur Steuerung der MR-Anordnungen.

In der Magnetresonanztomographie (MR-Tomographie) werden häufig Empfangsspulenanordnungen mit mehreren Empfangsspulen anstelle einer einzigen Empfangsspule verwendet, um bei vorgegebener MR-Sequenz und Akquisitionszeit ein erhöhtes Signal-zu-Rausch-Verhältnis sowie eine verbesserte räumliche Auflösung zu erhalten. Dafür sind geeignete Rekonstruktionsalgorithmen erforderlich, von denen eine Vielzahl bekannt ist. Ein Verfahren, mit dem sich eine starke Verbesserung erzielen lässt, ist das sogenannten SENSE-Verfahren, das aus "SENSE: Sensitivity Encoding for Fast MRI", Pruessmann, K. et al., Magnetic Resonance in Medicine, 42:952-962 (1999) bekannt ist. Das SENSE-Verfahren erlaubt es vornehmlich, die Messzeit mit einem praktikablen Verfahren zu reduzieren. Weitere bekannte Methoden zielen vornehmlich auf eine Verbesserung des Signal-zu-Rausch-Verhältnisses ab.

Bei diesem Verfahren werden entweder Informationen über die Empfindlichkeitsprofile dazu benutzt, um individuelle Beiträge (MR-Daten) jeder Empfangsspule zu einem MR-Gesamtbild entsprechend der räumlichen Anordnung zu gewichten oder um zwischen den Beiträgen von verschiedenen räumlichen Orten zu einzelnen erfassten MR-Daten zu differenzieren. Allerdings sind diese Verfahren nicht sehr robust, wenn das tatsächliche Spulenempfindlichkeitsprofil von dem in der Rekonstruktion benutzten Spulenempfindlichkeitsprofil abweicht, so dass in rekonstruierten MR-Bildern dann Intensitäts-Inhomogenitäten und Rückfaltungsartefakte auftreten. Insbesondere das SENSE-Verfahren ist in dieser Hinsicht sehr empfindlich.

Wenn zur Erfassung von MR-Daten Empfangsspulen verwendet werden, die während der gesamten Datenerfassung nicht an einem festen Ort bleiben, wird die Annahme von invarianten Empfangsspulenempfindlichkeiten verletzt. Insbesondere Bewegungen als auch Deformierungen tragen zu geänderten räumlichen Spulenempfindlichkeiten bei. Eine Möglichkeit, derartigen Änderungen der Empfangsspulenempfindlichkeiten während der Datenerfassung zu begegnen, wäre, bei vermuteten signifikanten Spulenbewegungen erneut Kalibrierungsdaten zu erfassen, um das aktuelle Spulenempfindlichkeitsprofil neu zu bestimmen. Dies würde jedoch einen zusätzlichen Aufwand an Messzeit und Datenverarbeitung erfordern, was abhängig von der jeweiligen Anwendung entweder nicht wünschenswert oder nicht möglich ist.

Auch bei der Anregung des Untersuchungsbereichs mittels einer Erregerspulenanordnung, welche mindestens eine Erregerspule aufweist, wird implizit angenommen, dass die Profile der einzelnen Spulen invariant über die Zeit sind.

Der Erfindung liegt deshalb die Aufgabe zugrunde, ein MR-Verfahren und eine MR-Anordnung anzugeben, bei denen MR-Bilder mit verbesserter Bildqualität erstellt werden können, auch wenn bewegliche und/oder flexible Empfangsspulen und/oder Erregerspulen Verwendung finden und bei denen insbesondere die beschriebenen Nachteile vermieden werden.

Diese Aufgabe wird erfindungsgemäß durch ein MR-Verfahren gemäß Anspruch 1 und ein MR-Verfahren gemäß Anspruch 5 gelöst. Bei der Erfassung von MR-Daten wird dabei vorgeschlagen, Positions- und Lageinformationen der Empfangsspulen zu ermitteln und die Eingangsdaten der Rekonstruktion anhand der ermittelten Positions- und Lageinformationen zum Ausgleich von Positions- und/oder Lageveränderungen der Empfangsspulen während der Erfassung der MR-Daten vor der Rekonstruktion der MR-Bilder zu korrigieren. Bei der Anregung des Untersuchungsbereichs wird entsprechend vorgeschlagen, Positions- und Lageinformationen der mindestens einen Erregerspule zu ermitteln und das Anregungssignal der mindestens einen Erregerspule anhand der ermittelten Positions- und Lageinformationen zum Ausgleich von Positions- und/oder Lageveränderungen der mindestens einen Erregerspule zu korrigieren. Die Erfindung wird außerdem auch durch einen MR-Anordnung nach Anspruch 6 oder 7 sowie durch ein Computerprogramm gemäß Anspruch 13 gelöst.

Der Erfindung liegt die Erkenntnis zugrunde, dass es für eine Reihe von Applikationen vorteilhaft ist, nicht vor, während oder nach der Erfassung von MR-Daten erneute Kalibrationsmessungen vorzunehmen, um das Empfindlichkeits- bzw. Anregungsprofil von Spulen neu zu bestimmen, da es sich möglicherweise aufgrund von Bewegungen während oder zwischen Akquisitionen verändert hat, sondern im Verlauf der Messung Positionsund Lageinformationen der Spulen zu erfassen und diese bei der Rekonstruktion der MR-Bilder unmittelbar zu berücksichtigen. Mit geeigneten Mitteln, insbesondere mittels einer Positionsmesseinrichtung, sollen dabei Bewegungen und/oder Deformationen von Spulen erfasst werden. Eine Kalibrationsmessung zur Bestimmung des Empfindlichkeitsprofils der mindestens einen Empfangsspule bzw. des Anregungsprofils der mindestens einen Erregerspule ist somit nur ein einziges Mal vor der Erfassung der MR-Daten erforderlich.

Prinzipiell könnte auch vollständig auf Kalibrationsmessungen verzichtet werden, und theoretische Modelle über die Feldverteilung der Spulen könnten genutzt werden, um aus der Kenntnis der Spulenposition und -lage das jeweilige Empfindlichkeitsprofil zu schätzen. Spätere Abweichungen von diesen Profilen können dann anhand der ermittelten Positions- und Lageinformationen korrigiert werden.

Wie in bevorzugten Ausgestaltungen vorgesehen ist, können als die genannten Eingangsdaten der Rekonstruktion anhand der gemessenen Positions- und Lageinformationen der Empfangsspulen sowohl die Empfindlichkeitsprofile der einzelnen Empfangsspulen, aus den erfassten MR-Daten der einzelnen Empfangsspulen ermittelte Einzelbilder oder auch die erfassten MR-Daten selbst erfindungsgemäß korrigiert werden, bevor ein MR-Gesamtbild rekonstruiert wird

In analoger Weise kann das aus einer anfangs vorgenommenen Kalibrationsmessung gewonnene Anregungsprofil einer Erregerspule anhand der ermittelten Positions- und Lageinformationen der Erregerspule während der Datenerfassung korrigiert werden. In diesem Fall muss die Neuberechnung des Anregungssignals für die einzelnen Sendespulen unmittelbar erfolgen, d. h. aus der ermittelten Position und Lage wird das Empfindlichkeitsprofil geschätzt, daraus das veränderte Anregungssignal berechnet, und dies unmittelbar ausgeführt.

Zur Korrektur können beispielsweise affine oder elastische Transformationen verwendet werden, oder es kann auch eine direkte Berechnung des veränderten Profils oder eine Kombination beider Methoden erfolgen. Durch die Erfindung lassen sich somit MR-Bilder mit deutlich erhöhter Bildqualität auch bei Bewegungen oder Deformationen von Empfangs- bzw. Erregerspulen erreichen, und Artefakte können weitgehend vermieden werden.

Zur Ermittlung der Positions- und Lageinformationen wird bevorzugt eine Positionsmesseinrichtung verwendet. Diese kann grundsätzlich beliebig ausgestaltet sein, beispielsweise auf einem optischen, elektromagnetischen oder Mikrospulen-basierten Prinzip beruhen. So kann beispielsweise an einem Stativ eine Kamera angebracht sein, mittels der die Position von an den Spulen angsbrachten LEDs im Raum mit hoher Genauigkeit bestimmt werden kann. Wesentlich ist bei der Positionsmesseinrichtung, dass die Messgenauigkeit der Positionsmessung möglichst groß ist, vorzugsweise in der Größenordnung eines Bildpixels oder darunter. Vorteilhaft ist weiterhin, wenn die Messung kontinuierlich erfolgen kann. Grundsätzlich kann jedoch auch die MR-Anordnung selbst, d.h. die Anregungs- und Empfangsspulen der MR-Anordnung zur Erfassung von Positions- und Lageinformationen der Spulen verwendet werden.
In einer weiteren Ausgestaltung der erfindungsgemäßen MR-Anordnungen sind flexible Spulen vorgesehen, die einen steifen Zustand annehmen können, wenn MR-Daten erfasst werden sollen. Auch hierfür sind verschiedene Prinzipien, wie sie in den Ansprüchen 10 und 11 angsgeben sind, grundsätzlich denkbar. Wesentlich ist dabei, dass die Spulen, wobei dies sowohl für Erregerspulen als auch für Empfangsspulen gilt, solange flexibel und beweglich sein können, solange keine Daten erfasst werden. Wenn jedoch die Akquisition von Daten beginnt, werden die Spulen in den steifen Zustand gebracht, so dass sie sich nicht mehr oder nur in geringem Maße bewegen oder verbiegen können. Dadurch kann eine zusätzliche Verbesserung der letztendlich rekonstruierten MR-Bilder erreicht werden. Der Schmelzpunkt der in der Ausgestaltung gemäß Anspruch 11 verwendeten Flüssigkeit kann so gewählt sein, dass sie bei Umgebungstemperatur flüssig ist und sich bei wenigen Grad unterhalb der Umgebungstemperatur verfestigt, so dass die Spulen durch Kühlen des Behältnisses bei der Datenerfassung in den steifen Zustand gebracht werden können oder dass sie bei Umgsbungstemperatur fest ist und sich bei wenigen Grad oberhalb der Umgebungstemperatur verflüssigt, so dass die Spulen durch Erwärmen des Behältnisses bei der Positionierung der Spulen in den flexiblen Zustand gebracht werden können.

In einer weiteren Ausgsstaltung der erfindungsgemäßen MR-Anordnungen ist vorgssehen, in Lücken zwischen dem Untersuchungsobjekt und einer oder mehreren Spulen der Empfangsspulen- bzw. Erregerspulenanordnung ein Material anzuordnen, welches bei der Erfassung der MR-Daten kein MR-Signal liefert, sondern nur während einer Kalibrationsmessung zur Bestimmung der Spulenempfindlichkeit einer Empfangsspule bzw. zur Bestimmung des Erregerfeldes einer Anregungsspule ein MR-Signal liefert. Dadurch kann erreicht werden, dass das mittels der Kalibrationsmessung erfasste Empfindlichkeitsprofil bzw. Erregerfeld mit hoher Genauigkeit bestimmt werden kann, da es in dem Zwischenraum zwischen dem Untersuchungsobjekt und der Spule keinen Signalverlust gibt während der Kalibrationsmessung. Somit ist auch in diesem Zwischenraum nach der Kalibrationsmessung das Empfindlichkeitsprofil bzw. das Erregerfeld bekannt. Andererseits liefert das in diesem Zwischenraum befindliche Material keinen Beitrag zu den gemessenen MR-Daten, so dass das MR-Bild letztlich dadurch nicht verfälscht wird. Die Bestimmung des Empfindlichkeitsprofils im Außenraum' des Patienten ist insbesondere deshalb von Interesse ist, da eine folgende Bewegung dazu führen kann, dass Schätzungen für diesen Bereich plötzlich benötigt werden in der Bildrekonstruktion.

Die Erfindung wird nachfolgend anhand der Zeichnungen näher erläutert. Es zeigen:
- Figur 1: eine erfindungsgemäße MR-Anordnung mit einer Empfangsspulenanordnung,
- Figur 2: ein Ablaufdiagramm eines erfindungsgämäßen MR-Verfahrens zur Anwendung bei einer MR-Anordnung nach Figur 1,
- Figur 3: eine erfindungsgemäße MR-Anordnung mit einer Erregerspulenanordnung und
- Figur 4: ein Ablaufdiagram eines erfindungsgemäßen MR-Verfahrens zur Anwendung bei einer MR-Anordnung gemäß Figur 3.

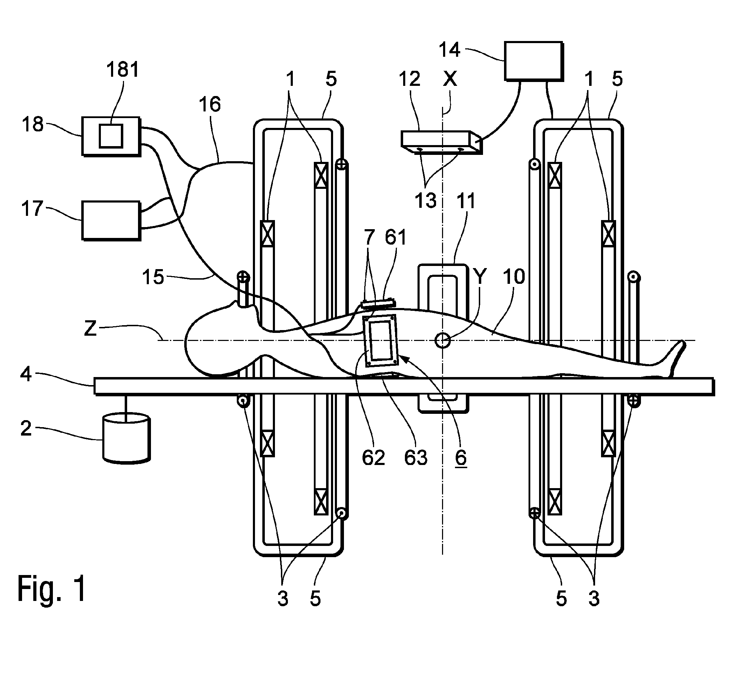

In Figur 1 ist eine erste Ausgestaltung einer erfindungsgemäßen MR-Anordnung mit einer Empfangsspulenanordnung gezeigt. Diese MR-Anordnung weist einen Hauptfeldmagneten 1 auf, der in z-Richtung ein stationäres und im wesentlichen homogenes Magnetfeld mit einer Stärke von z. B. 1,5 Tesla erzeugt. Der Hauptfeldmagnet 1 ist konzentrisch um die z-Achse und den auf einem Patiententisch 4 liegend angeordneten Patienten 10 angeordnet. Da der Hauptfeldmagnet 1 zweigeteilt ausgestaltet ist, ist der mittlere Bereich des Körpers des Patienten 10 von außen zugänglich.

Weiterhin sind verschiedene Gradientenspulen-Anordnungen 3, 5 vorgesehen, mit denen in z-Richtung verlaufende Gradienten-Magnetfelder mit einem Gradienten in x-, y- bzw. z-Richtung erzeugt werden können. Zur Anregung des Untersuchungsbereichs ist eine Erregerspulenanordnung vorgesehen, die vorliegend nur eine einzige stationäre Erregerspule 11 umfasst. Diese Spule 11 kann gleichzeitig auch als stationäre Empfangsspule eingesetzt werden. Mittels eines Motors 2 kann der auf dem Patiententisch 4 liegende Patient 10 in z-Richtung verfahren werden, um den Untersuchungsbereich innerhalb des stationären Magnetfeldes am besten zu positionieren. Weitere bei einer MR-Anordnung notwendigerweise vorhandene Elemente wie beispielsweise Verstärker für die einzelnen Spulen, Generatoren, Bedien- und Anzeigeelemente sind allgemein bekannt und sollen deshalb nicht näher gezeigt und erläutert werden.

Mittels einer Empfangsspulenanordnung 6, die rings um den Patienten 10 um den Untersuchungsbereich, vorliegend den Brustkorb in Höhe des Herzens, angeordnet ist, sollen die im Untersuchungsbereich erzeugten MR-Signale erfasst werden. Die erfassten MR-Daten werden über eine Verbindungsleitung 15 einer Steuereinheit 17 und einer Rekonstruktionseinheit 18 zugeführt. Beide Einheiten 17,18 stehen auch über eine Leitung 16 mit allen weiteren Spulen 1, 3, 5, 11 in Verbindung. Mittels der Steuereinheit 17 wird die MR-Anordnung gesteuert, insbesondere die Erzeugung der zur Datenerfassung erforderlichen Magnetfelder. Mittels der Rekonstruktionseinheit 18 werden die insbesondere von der Empfangsspulenanordnung 6 erfassten MR-Daten verarbeitet und gewünschte MR-Bilder daraus erzeugt.

Im vorliegenden Fall weist die Empfangsspulenanordnung 6 vier Empfangsspulen 61, 62, 63 (eine vierte Empfangsspule befindet sich gegenüberliegend der Empfangsspule 62 und ist deshalb nicht sichtbar) auf, die rings um den Brustkorb des Patienten 10 herum angeordnet sind. Diese Empfangsspulen 61, 62, 63 sind flexibel ausgestaltet, um sich der Körperoberfläche des Patienten 10 möglichst gut anpassen zu können. Außerdem sind die Empfangsspulen 61, 62, 63 grundsätzlich zwar durch mit Klettverschlüssen versehene dehnbare Bänder provisorisch fixiert, aber dennoch beweglich, das heißt, sie können bei Bewegungen des Patienten 10 während der Datenerfassung ihre Position und Lage ändern, beispielsweise verrutschen, verdreht oder gar verbogen werden.

Zur Erfassung der jeweils aktuellen Position der Empfangsspulen 61, 62, 63 während der Datenerfassung ist deshalb erfindungsgämäß eine Positionsmesseinrichtung vorgesehen. Diese weist im vorliegenden Fall eine Kameraeinheit 12 mit zwei voneinander beabstandeten Kameras 13, beispielsweise CCD-Kameras, auf, die über eine Recheneinheit 14 mit dem gesamten System und somit auch mit der Steuereinheit 17 und der Rekonstruktionseinheit 18 verbunden sind. Die Kameras 13 sind so ausgestaltet und ausgerichtet, dass sie optische Signale, die von speziell dafür vorgesehenen optischen Markern 7, beispielsweise im sichtbaren oder Infrarot-Bereich arbeitenden LEDs, empfangen können, die an jeder der Empfangsspulen 61, 62, 63 angeordnet sind. Die Anzahl und Anordnung der optischen Marker 7 ist dabei derart vorgesehen, dass sich aus den einzelnen Positionen der Marker 7 die Position und Lage der zugehörigen Empfangsspule bestimmen lässt. Insbesondere sollen Positions- und Lageveränderungen der Empfangsspulen 61, 62, 63 während der Datenerfassung mittels der Kameras 13 detektiert werden. Zur Auswertung der gemessenen Positionsdaten werden diese an eine entsprechende Recheneinheit 14 geliefert, die zunächst die räumlich Position der einzelnen optischen Marker 7 bestimmt, daraus die Position und Lage der einzelnen Empfangsspulen 61, 62, 63 ermittelt und anhand dessen feststellt, ob sich Positions- und/oder Lageveränderungen ergeben haben verglichen mit einer Referenzmessung.

Zwar kann die Positionsbestimmung einzelner Spulen, wie z. B. der Spule 63, Schwierigkeiten bereiten. Einerseits wird jedoch davon ausgegangen, dass diese Spule sich nur wenig bis gar nicht bewegen kann. Andererseits können auch andere Verfahren, z.B. elektromagnetische Verfahren, verwendet werden, um die Position solcher Spulen zu bestimmen.

Sofern Positions- und/oder Lageveränderungen festgestellt werden, kann mittels einer Korrektureinheit 181 in der Rekonstruktionseinheit 18 eine Korrektur der Eingangsdaten der Rekonstruktion vorgenommen werden. Dazu kann beispielsweise für jede Empfangsspule 61, 62, 63 einzeln das jeweilige räumliche Empfindlichkeitsprofil, das aus einer eingangs vorgenommenen Kalibrationsmessung bekannt ist, korrigiert, insbesondere räumlich angepasst, werden. Alternativ können auch aus den ermittelten MR-Daten jeweils einer Empfangsspule 61, 62, 63 erstellte MR-Einzelbilder zunächst korrigiert werden, bevor sie zu einem MR-Gesamtbild kombiniert werden. Als weitere Alternative könnten auch die MR-Daten direkt korrigiert werden, bevor die Einzelbilder und daraus dann das MR-Gesamtbild rekonstruiert werden.

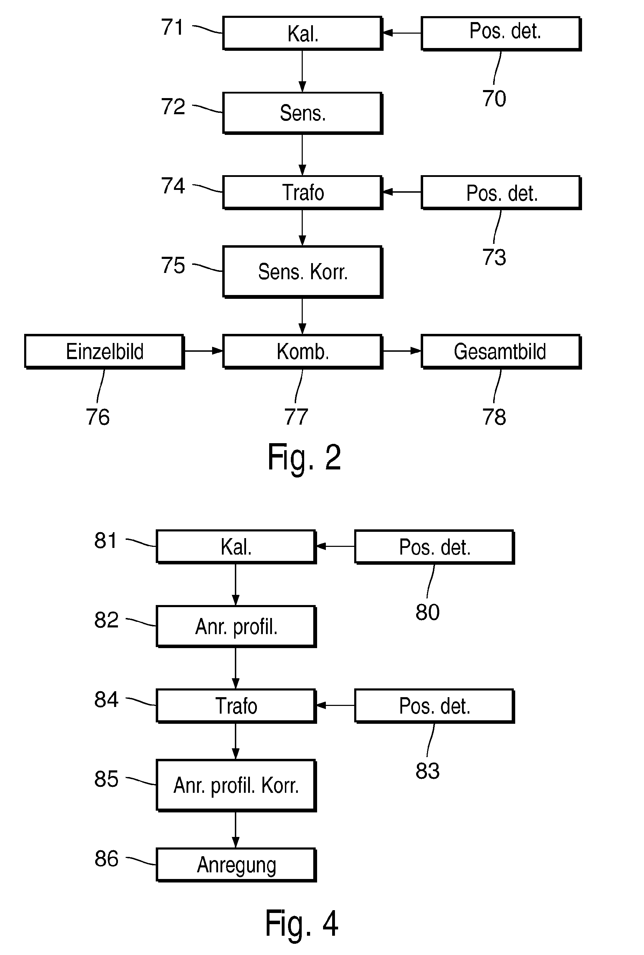

Anhand des Ablaufdiagramms in Figur 2 soll nun das erfindungsgemäße MR-Verfahren noch näher erläutert werden. In einem ersten Schritt 70 wird für die anfängliche Spulenkonfiguration die Position und Orientierung jeder einzelnen Empfangsspule 61, 62, 63 bestimmt. In einem Kalibrationsschritt 71 wird außerdem eine Kalibrationsmessung durchgeführt. Dabei sollte sichergestellt werden, dass sich Position und Orientierung der Empfangsspulen nicht verändern. Dies ist zum Beispiel durch geeignete Messverfahren mit Gating oder Triggering möglich, die es nicht erforderlich machen, die Spulen in irgend einer Weise zu fixieren für die Dauer dieser Messung. Im allgemeinen beträgt die Messzeit für die Kalibrationsmessung allerdings nur etwa eine Minute. Daher ist dabei das Problem der Patientenbewegung relativ klein.

In einem nachfolgenden Schritt 72 kann dann aus den ermittelten Daten der Schritte 70 und 71 das räumliche Empfindlichkeitsprofil der einzelnen Empfangsspulen ermittelt werden.

Während der Akquisition der MR-Daten kann nun laufend oder in regelmäßigen Zeitabständen mittels der Positionsmesseinrichtung die Position und Lage der einzelnen Empfangsspulen überwacht werden (Schritt 73). Falls eine, ein bestimmtes Maß überschreitende Veränderung der Position oder Lage, beispielsweise ein Verschieben einer Empfangsspule oder eine Deformation einer Empfangsspule, festgestellt wird, kann dann in Schritt 74 eine entsprechende Transformation des eingangs bestimmten Empfindlichkeitsprofils der betroffenen Empfangsspule bestimmt werden, um dieses dann im Schritt 75 entsprechend zu korrigieren. Das entsprechend korrigierte Empfindlichkeitsprofil wird dann auch bei der Rekonstruktion in Schritt 77 verwendet, bei der die aus den von den einzelnen Empfangsspulen erfassten MR-Daten ermittelten Einzelbilder (Schritt 76) kombiniert werden, um ein darstellbares und gewünschtes MR-Gesamtbild zu erzeugen (Schritt 78).

Es wurde bereits erwähnt, dass die Positions- und Lagebestimmung in Schritt 73 laufend während der Akquisition der MR-Daten erfolgen kann. Deshalb kann grundsätzlich für jeden MR-Datensatz das jeweils aktuelle Empfindlichkeitsprofil der einzelnen Empfangsspulen bestimmt werden, wodurch sich die höchste Genauigkeit erreichen lässt. In diesem Fall wird im Prinzip für jeden Messwert ein eigenständiger Satz von Empfindlichkeitsprofilen der Rekonstruktion zur Verfügung gestellt. Die Rekonstruktionsverfahren müssen entsprechend modifiziert werden, um die zeitliche Abhängigkeit der einzelnen Messdaten von den unterschiedlichen Empfindlichkeitsprofilen zu berücksichtigen.

Tritt beispielsweise nach der Hälfte der Datenakquisition für ein Bild eine signifikante Bewegung der Spulen auf, so kann bevorzugt die Rekonstruktion separat für beide Teildatensätze ausgeführt werden mit einem entsprechend verdoppelten Reduktionsfaktor. Im Anschluss sind die jeweiligen Ergsbnisse geeignet zu kombinieren.

Für das beschriebene Verfahren ist allerdings ein hoher Rechenaufwand erforderlich. Vorzugsweise wird nur dann ein korrigiertes Empfindlichkeitsprofil für einzelne Empfangsspulen bestimmt, wenn die Bewegung oder Deformation einer Empfangsspule ein bestimmtes Maß überschritten hat. Jedoch lässt sich auch damit eine deutliche Verbesserung in der Bildqualität sowie eine höhere räumliche und zeitliche Auflösung von MR-Bildem erreichen.

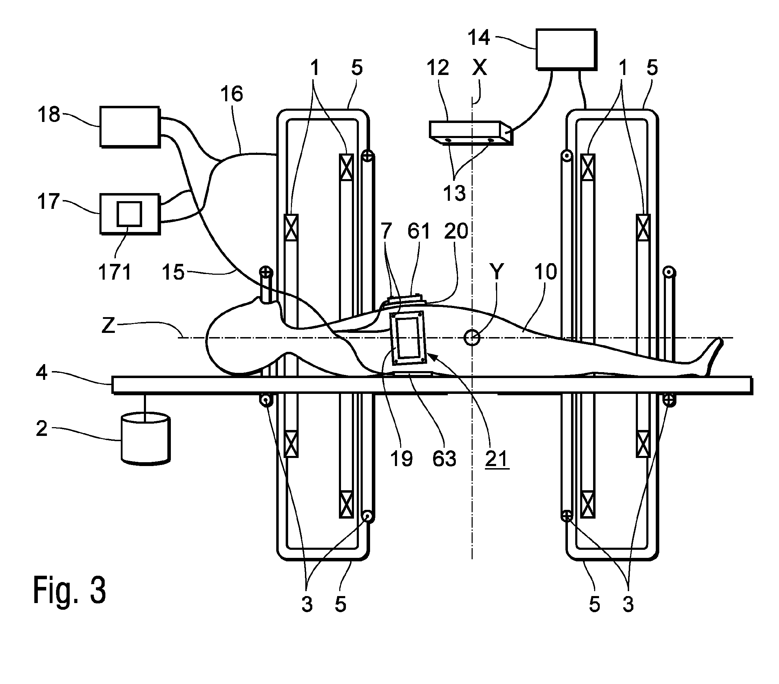

Eine weitere Ausgsstaltung einer erfindungsgemäßen MR-Anordnung mit einer Erregerspulenanordnung 21 ist in Figur 3 gezeigt. Das zugehörige Ablaufdiagramm ist in Figur 4 gezeigt. Die Erregerspulenanordnung 21 weist dort eine Erregerspule 19 auf, die gleichzeitig auch als Empfangsspule arbeiten kann. Als Empfangsspule bildet diese somit zusammen mit weiteren Empfangsspulen 61 und 63 sowie einer vierten, nicht sichtbaren Empfangsspule die auch bereits in Figur 1 gezeigte Empfangsspulenanordnung. Auch die Anregungsspule 19 steht wiederum mit der Steuereinheit 17 und der Rekonstruktionseinheit 18 in Verbindung. Alle weiteren Elemente der MR-Anordnung sind in ähnlicher oder identischer Weise wie bei der in Figur 1 gezeigten MR-Anordnung vorhanden. Lediglich die dort gezeigte Erregerspule 11 kann hier entfallen.

Aufgrund der Reziprozität ist für jede Spule das Empfindlichkeitsprofil identisch zu dem resultierenden Anregungsprofil, wenn sie zur Erzeugung eines Magnetfeldes benutzt wird. Um eine bestimmte Anregung des Untersuchungsbereichs zu erreichen, ist es deshalb erforderlich, das mittels des Anregungssignal erzielte Anregungsfeld möglichst genau zu kennen. Dieses kann beispielsweise für eine Spule berechnet werden, wenn das Empfindlichkeitsprofil der Spule bekannt ist. Daraus wird auch klar, dass eine Veränderung der Position und Lage einer Spule auch zu einer Veränderung des Anregungsfeldes der Spule führt, so dass die während einer MR-Daten-Akquisition mehrfach erfolgende Anregung mittels eines Anregungssignals angepasst werden muss, wenn sich die Position und Lage der Anregungsspule während der Akquisition verändert.

Dies ist in dem in Figur 4 gezeigten Ablaufdiagramm näher erläutert. Zunächst wird aus den anfänglichen Positions- und Kalibrationsmessungen (Schritte 80 und 81) das anfängliche Anregungsprofil der Erregerspule bestimmt (für 82). Während der Akquisition kann dann auch die Position und Lage der Erregerspule mittels derselben Positionsmesseinrichtung detektiert werden (Schritt 83), wenn an der Erregerspule ebenfalls die auf die Positionsmesseinrichtung abgestimmten Marker 7 angebracht sind. Wenn sich eine Positionsund/oder Lageveränderung der Erregerspule aus dieser Messung ergibt, kann eine Transformationsvorschrift in Schritt 84 bestimmt werden, um anschließend in Schritt 85 das Anregungsprofil der Erregerspule zu korrigieren. Dies kann somit laufend während der Akquisition erfolgen, so dass der Untersuchungsbereich immer mit dem optimalen und gewünschten Erregerfeld angeregt wird (Schritt 86). Zur Korrektur des Anregungssignals sind dazu in der Steuereinheit 17 geeignete Korrekturmittel 171 vorgesehen.

Dieses Verfahren führt letztlich wiederum dazu, dass aufgrund der größeren Übereinstimmung zwischen gewünschter Anregung und tatsächlicher Anregung MR-Bilder mit höherer Genauigkeit und insbesondere größerer zeitlicher und räumlicher Auflösung erstellt werden können.

Als Positionsmesseinrichtung kommt grundsätzlich jede Messeinrichtung in Frage, bei der mit möglichst geringem Aufwand die Position und Lage der Spulen möglichst genau bestimmt werden kann. Beispielhaft sollen hier einige Möglichkeiten näher erläutert werden:
a) Wie in den Figuren 1 und 3 erläutert, kann eine optische Positionsmesseinrichtung eingesetzt werden, bei der mittels Kameras die von geeigneten Markern, z. B. LEDs, ausgesendete optische Signale zur Positionsbestimmung ausgewertet werden. Da davon ausgegangen wird, dass sich die Spulen unterhalb des Patienten nur in geringem Maße bewegen oder verändern während der Akquisition, können dort auch solche optischen Marker entfallen. Eine zusätzliche Messzeit zur Erfassung von weiteren MR-Daten ergibt sich hierbei nicht.
b) Alternativ können auch elektromagnetische Marker verwendet werden, die mit einer geeigneten Messeinrichtung lokalisiert werden können. Auch hierbei ist keine zusätzliche MR-Messzeit erforderlich.
c) An den Spulen können auch aktive oder passive Mikrospulen angebracht sein, die aus dem Untersuchungsbereich ebenfalls ein MR-Signal aufnehmen können bzw. selbst ein von den Empfangsspulen wahrnehmbares MR-Signal aussenden können, woraus sich letztlich die Position der Mikrospulen und somit der Empfangs- bzw. Erregerspulen bestimmen lässt. Jedoch wäre hierfür zusätzliche Messzeit abhängig von der verwendeten MR-Sequenz erforderlich.
d) Grundsätzlich kann jedoch auch - wie bereits erwähnt - die MR-Anordnung selbst zur Bestimmung der Positions- und Lageinformationen verwendet werden.

Flexible Spulenelemente, die in stärkerem Maße deformiert werden können, erfordern zur Positionsbestimmung mehr als drei Punkte des Spulenelements, um die Deformation entsprechend beschreiben zu können. Die Positionsbestimmung und die entsprechende Anpassung des Empfindlichkeitsprofils bei einer Empfangsspule ist deshalb recht komplex. Es kann deshalb vorteilhaft sein, die Flexibilität solcher Spulen mechanisch zu begrenzen während der Akquisition, indem bei solchen Spulen Maßnahmen vorgesehen werden, um zwischen einem flexiblen und einem steifen Zustand umschalten zu können. Solche Spulen können dann in den flexiblen Zustand geschalten werden, um sie zu positionieren und somit optimal an die Körperoberfläche anzupassen. Zur Datenerfassung werden sie dann jedoch in den steifen Zustand geschaltet, so dass keine Deformierung mehr möglich ist und die Positionsbestimmung anhand von drei Punkten auf den Spulen ausreicht, um gegebenenfalls eine Bewegung feststellen zu können.

Für solche Spulen sind verschiedene Ausgestaltungen denkbar. Beispielsweise kann eine solche Spule hergestellt werden, in dem ein luftdichtes Behältnis, das beispielsweise mit kleinen Styroporkugeln gefüllt ist, an der Spule angebracht wird. So lange, wie das Behältnis unter normalen Umgebungsdruck steht, ist die Spule flexibel. Sobald jedoch das Behältnis evakuiert wird, werden die Kugeln aneinandergepresst, so dass das Behältnis steif wird. Diese Technik ist beispielsweise aus Notarztwagen bekannt, wo sie zur Fixierung eines Patienten auf der Krankenliege während des Transports benutzt wird.

Als zweite Möglichkeit könnten solche Spulen dadurch realisiert werden, dass ein Behältnis an der Spule angebracht ist, das mit einem Material gefüllt ist, das einen Schmelzpunkt etwa bei Umgebungstemperatur aufweist. Wird das Material um wenige Grad erhitzt, kann die Spule flexibel gemacht werden, da sich das Material verflüssigt; wird das Material wieder abgekühlt, verfestigt es sich, so dass die Spule wieder steif ist.

Es sind Fälle denkbar, bei denen eine anfänglich Bestimmung des Anregungs- bzw. Empfindlichkeitsprofils einer Spule nicht für alle Ortspunkte möglicht ist, da beispielsweise in bestimmten Regionen innerhalb oder außerhalb des Patienten kein MR-Signal während der Kalibrationsmessung gemessen werden kann. Die Transformation des Anregungs- bzw. Empfindlichkeitsprofils zur Berücksichtigung von Positions- und Lageveränderungen erfordert deshalb oft Extrapolationen. Derartige Extrapolationen können auf Basis verschiedener Prinzipien durchgeführt werden, beispielsweise mittels lokaler oder globaler Anpassungen an analytische Funktionen wie Polynome oder an theoretisch bekannte Empfindlichkeitsprofilverteilungen von Spulen. Alternativ dazu besteht jedoch auch die Möglichkeit, eine eventuelle Lücke zwischen einer Spule und dem Patienten mit einem Material 20 auszufüllen, wie es in Figur 3 gezeigt ist. Dieses Material sollte so ausgestaltet sein, dass es während einer Kalibrationsmessung ein MR-Signal liefert, aber während der tatsächlichen MR-Datenerfassung nur ein geringes oder kein Signal liefert. Dazu werden vorzugsweise sehr kurze T₂- oder T₂*-Materialien, z. B. hochkonzentrierte Salzlösungen oder Polymere verwendet in Kombination mit MR-Sequenen von sehr kurzen Echozeiten, z. B. TE<0.3 ms für die Kalibrationsmessung. In solchen MR-Sequenzen sind derartige Materialien dann sichtbar, während sie in MR-Sequenzen mit normalen Echozeiten wie für die Erfassung der MR-Daten während der Bildgebung verwendet unsichtbar bleiben.

Die Erfindung kann noch weitergehend auch angswendet werden, um die Bewegung auch während der Akquisition eines einzigen MR-Datensatzes mit noch höherer zeitlicher Auflösung zu korrigieren. Im einfachsten Fall wird jeder Satz von k-Raum-Daten, bei dessen Akquisition keine signifikante Spulenbewegung aufgstreten ist, separat rekonstruiert. Die resultierenden Teilbilder werden dann kombiniert, wobei die entsprechend gültigen Empfindlichkeitsprofile benutzt werden. In schwierigeren Fällen variieren die Empfindlichkeitsprofile in der Kodierungsmatrix mit der Zeit und hängen deshalb nicht nur von der Position im Ortsraum, sondern auch von der Position im Frequenzraum ab. Ein allgemeinerer Formalismus, wie er beispielsweise im Zusammenhang mit nicht-karthesischen Akquisitionen unter Benutzung des SENSE-Verfahrens vorgeschlagen wird, muss dann bei der Rekonstruktion angewendet werden.

Grundsätzlich kann eine Korrektur des Empfindlichkeits- bzw. Anregungsprofils mittels einer einfachen Koordinatentransformation vorgenommen werden, wenn lediglich eine Bewegung oder Verdrehung einer Spule erfolgt ist. Bei einer Deformation einer Spule ist die Korrektur wesentlich schwieriger. Dann könnte beispielsweise das Feldprofil der Spule neu berechnet werden, gegebenenfalls unter Ausnutzung von Kenntnissen über die Gewebeempfindlichkeit oder durch einen Vergleich mit dem anfänglichen bei der Kalibrationsmessung gefundenen Profil. Alternativ könnten dann auch Modelle für eine Transformation angewendet werden.

Schließlich kann das erfindungsgämaße Verfahren, insbesondere die ermittelten Positionsund Lageinformation, auch dazu verwendet werden, die gegenseitige Kopplung bzw.

Rauschkorrelation zweier benachbarter Spulen zu bestimmen. Diese Kenntnis kann dann dazu genutzt werden, um eine verbesserte virtuelle Entkopplung der Spulen vorzunehmen, um so letztendlich wieder MR-Bilder mit verbesserter Bildqualität zu erhalten.

## Patentansprüche

1. MR-Verfahren zur Ermittlung von MR-Bildern eines Untersuchungsbereichs eines Untetsuchungsobjekts (10), wobei mittels einer mindestens eine bewegliche und/oder flexible Empfangsspule (61, 62, 63) aufweisenden Emfpangsspulenanordnung (6) MR-Daten aus dem Untersuchungsbereich erfasst werden und wobei aus den erfassten MR-Daten die MR-Bilder rekonstruiert werden,
**dadurch gekennzeichnet,**
**dass** bei der Erfassung der MR-Daten Positions- und Lageinformationen der mindestens einen Empfangsspule (61, 62, 63) ermittelt werden und dass Eingangsdaten der Rekonstruktion anhand der ermittelten Positions- und Lageinformtionen zum Ausgleich von Positions- und/oder Lageveränderungen der mindestens einen Empfangsspule (61, 62, 63) während der Erfassung der MR-Daten vor der Rekonstruktion der MR-Bilder korrigiert werden.

2. MR-Verfahren nach Anspruch 1,
**dadurch gekennzeichnet,**
**dass** anhand der Positions- und Lageinformationen das Empfindlichkeitsprofil der mindestens einen Empfangsspulen (61, 62, 63) korrigiert wird.

3. MR-Verfahren nach Anspruch 1,
**dadurch gekennzeichnet,**
**dass** anhand der Positions- und Lageinformationen aus den erfassten MR-Daten der mindestens einen Empfangsspule (61, 62, 63) ermittelte Einzelbilder korrigiert werden vor einer Kombination der Einzelbilder zu einem MR-Gesamtbild.

4. MR-Verfahren nach Anspruch 1,
**dadurch gekennzeichnet,**
**dass** anhand der Positions- und Lagsinformationen die erfassten MR-Daten der mindestens einen Empfangsspule (61, 62, 63) korrigiert werden.

5. MR-Verfahren zur Ermittlung von MR-Bildern eines Untersuchungsbereichs eines Untersuchungsobjekts (10), wobei mittels einer mindestens eine bewegliche und/oder flexible Erregerspule (19) aufweisenden Erregerspulenanordnung (21) der abzubildende Untersuchungsbereich angsregt wird,
**dadurch gekennzeichnet,**
**dass** bei der Anregung des Untersuchungsbereichs Positions- und Lageinformationen der mindestens eine Erregerspule (19) ermittelt werden und dass das Anregungssignal der mindestens einen Erregerspule (19) anhand der ermittelten Positions- und Lageinformationen zum Ausgleich von Positions- und/oder Lageveränderungen der mindestens einen Erregerspule (19) während der Anregung korrigiert wird.

6. MR-Anordnung zur Ermittlung von MR-Bildern eines Untersuchungsbereichs eines Untersuchungsobjekts mit einer mindestens eine bewegliche und/oder flexible Empfangsspule (61, 62, 63) aufweisenden Empfangsspulenanordnung (6) zur Erfassung von MR-Daten aus dem Untersuchungsbereich, mit einer Rekonstruktionseinheit (18) zur Rekonstruktion von MR-Bildern aus den erfassten MR-Daten und mit Mitteln (12, 13) zur Erfassung von Positions- und Lageinformationen der mindestens einen Empfangsspule (61, 62, 63),
**dadurch gekennzeichnet,**
**dass** die Rekonstruktionseinheit (18) Mittel (181) aufweist zur Korrektur von Eingangsdaten der Rekonstruktion anhand der ermittelten Positions- und Lageinformationen der mindestens einen Empfangsspule (61, 62, 63) vor der Rekonstruktion der MR-Bilder zum Ausgleich von Positions- und/oder Lageveränderungen der mindestens einen Empfangsspule (61, 62, 63) während der Erfassung der MR-Daten.

7. MR-Anordnung zur Ermittlung von MR-Bildern eines Untersuchungsbereichs eines Untersuchungsobjekts (10) mit einer mindestens eine Erregerspule (19) aufweisenden Erregerspulenanordnung (21) zur Anregung des abzubildenden Untersuchungsbereichs, mit einer Steuereinheit (17) zur Steuerung der Erregerspulenanordnung (21) und mit Mitteln (12, 13) zur Ermittlung von Positions- und Lageinformationen der mindestens einen Erregerspule (19) bei der Anregung des Untersuchungsbereichs,
**dadurch gekennzeichnet,**
**dass** die Steuereinheit (17) Mittel (171) aufweist zur Korrektur des Anregungssignals der mindestens einen Erregerspule (19) zum Ausgleich von Positions- und/oder Lageveränderungen der mindestens einen Erregerspule (19) während der Anregung

8. MR-Anordnung nach Anspruch 6 oder 7,
**dadurch gekennzeichnet,**
**dass** eine Positionsmesseinrichtung (12, 13), insbesondere eine optische, elektromagnetische oder Mikrospulen-basierte Positionsmesseinrichtung zur Ermittlung der Positionsund Lageinformationen vorgesehen ist.

9. MR-Anordnung nach Anspruch 6 oder 7,
**dadurch gekennzeichnet,**
**dass** die Empfangsspulenanordnung (6) bzw. die Erregerspulenanordnung (21) flexible Spulen aufweist, die einen steifen Zustand annehmen können und dass die Spulen zur Erfassung der MR-Daten in den steifen Zustand gebracht werden.

10. MR-Anordnung nach Anspruch 9,
**dadurch gekennzeichnet,**
**dass** die Spulen der Empfangsspulenanordnung (6) und/oder der Erregerspulenanordnung (21) je ein luftdichtes Behältnis aufweisen, in dem ein Füllmaterial derart angeordnet ist, dass die Spulen in normalem Zustand flexibel und während der Erfassung der MR-Daten durch zumindest teilweise Evakuierung des Behältnisses steif sind.

11. MR-Anordnung nach Anspruch 9,
**dadurch gekennzeichnet,**
**dass** die Spulen der Empfangsspulenanordnung (6) und/oder der Erregerspulenanordnung (21) je ein mit einer Flüssigkeit gefülltes Behältnis aufweisen, wobei die Flüssigkeit einen geeigneten Schmelzpunkt aufwdst, so dass durch leichtes Erwärmen bzw. Abkühlen ein Übergang von einem flüssigen in einen festen Zustand ermöglicht wird

12. MR-Anordnung nach Anspruch 6 oder 7,
**dadurch gekennzeichnet,**
**dass** in Lücken zwischen dem Untersuchungsobjekt (10) und einer oder mehreren Spulen der Empfangsspulenanordnung (6) und/oder der Erregerspulenanordnung (21) ein Material (20) angeordnet ist, welches bei der Erfassung der MR-Daten kein MR-Signal liefert, sondern nur während einer Kalibrationsmessung zur Bestimmung der Spulenempfindlichkeit einer Empfangsspule bzw. des Erregerfeldes einer Anregungsspule ein MR-Signal liefert.

13. Computerprogramm zur Umsetzung des MR-Verfahrens nach Anspruch 1 oder 5 und/oder zur Steuerung einer MR-Anordnung nach Anspruch 6 oder 7.
